# EUROPEAN PATENT APPLICATION

(11) **EP 4 682 950 A1**
(43) Date of publication of application: **21.01.2026**
(21) Application number: 24770369.7
(22) Date of filing: 15.02.2024
(51) Int. Cl.: H01L 23/12, H01L 23/29, H01L 25/00, H05K 1/02

(54) **HIGH-FREQUENCY MODULE AND PHASED ARRAY ANTENNA MODULE**

(30) Priority: 13.03.2023 JP 2023038518
(71) Applicant: Fujikura Ltd., Tokyo 135-8512 (JP)
(72) Inventor: TOMITA, Michikazu, Sakura-shi, Chiba 285-8550 (JP)
(74) Representative: Lavoix
(86) International application number: PCT/JP2024/005244
(87) International publication number: WO 2024/190254

(57) **Abstract**

The present invention relates to a high-frequency module including an IC package in which a plurality of solder bumps are arranged on a plane and a substrate which has a mounting surface for mounting the IC package, wherein an inner metal pattern which is not electrically grounded is formed on the mounting surface at a portion overlapping with the IC package in a plan view, wherein the plurality of solder bumps include an RF bump through which a high-frequency signal passes and a GND bump which is electrically grounded, and wherein the GND bump is disposed on a shortest line segment connecting the RF bump and the inner metal pattern in a plan view.

## Description

### TECHNICAL FIELD

The present invention relates to a high-frequency module and a phased array antenna module.

Priority is claimed on Japanese Patent Application No. 2023-038518, filed March 13, 2023, the content of which is incorporated herein by reference.

### BACKGROUND ART

Patent Document 1 below discloses a wafer level chip size package (WL-CSP) type semiconductor device in which solder bumps are directly formed on a semiconductor chip without using a substrate.

### Citation List

### Patent Document

Patent Document 1: Japanese Patent No. 5039384

### SUMMARY OF INVENTION

### Technical Problem

A high-frequency module that handles a high-frequency signal is required to be smaller while satisfying high-frequency characteristics. Here, in order to reduce the size of the high-frequency module, a substrate portion (dead space) that overlaps with an IC package mounted on a substrate in a plan view may be used to form inner metal patterns which are not electrically grounded, such as power supply patterns and signal patterns. Therefore, there is a concern of high-frequency signals leaking from the solder bumps through which the high-frequency signals pass, via the inner metal pattern to other contacts.

The present invention has been made to solve the above-described problems and an object thereof is to improve isolation between a bump through which a high-frequency signal passes and an inner metal pattern which overlaps with an IC package in a plan view in a small high-frequency module that handles a high-frequency signal.

### Solution to Problem

A first aspect of the present invention is a high-frequency module including: an IC package in which a plurality of solder bumps are arranged on a plane; and a substrate which has a mounting surface for mounting the IC package, wherein an inner metal pattern is formed on the substrate to be disposed at a portion overlapping with the IC package in a plan view, wherein the plurality of solder bumps include an RF bump through which a high-frequency signal passes and a GND bump which is electrically grounded, and wherein the GND bump is disposed on a shortest line segment connecting the RF bump and the inner metal pattern in a plan view.

According to the first aspect of the present invention, in a plan view of the substrate, the GND bump disposed on the shortest line segment connecting the RF bump and the inner metal pattern acts as a wall that suppresses leakage of a high-frequency signal when the high-frequency signal is transmitted from the RF bump to the inner metal pattern. Therefore, it is possible to improve the isolation between the RF bump through which the high-frequency signal passes and the inner metal pattern that overlaps with the IC package in a plan view.

A second aspect of the present invention is the high-frequency module of the first aspect, wherein the RF bump is provided at a plurality of positions around the inner metal pattern in a plan view, and wherein the GND bump is further disposed between the RF bumps adjacent to each other.

A third aspect of the present invention is the high-frequency module of the first aspect or the second aspect, wherein the RF bump is disposed on an outermost edge of the IC package in a plan view.

A fourth aspect of the present invention is the high-frequency module of any one of the first aspect to the third aspect, wherein the RF bump, the GND bump, the inner metal pattern, another GND bump, and another RF bump are arranged in this order on a straight line including the shortest line segment which is an extension of both ends of the shortest line segment connecting the RF bump and the inner metal pattern.

A fifth aspect of the present invention is the high-frequency module of any one of the first aspect to the fourth aspect, wherein the IC package includes an IC chip, a molding resin which surrounds the IC chip in a plan view, an insulating layer which is formed on one surface of the IC chip and the molding resin, the plurality of solder bumps which are formed on the insulating layer, and a rewiring which is formed on the insulating layer and connects the IC chip to the plurality of solder bumps.

A sixth aspect of the present invention is the high-frequency module of the fifth aspect, wherein the rewiring connected to the RF bump extends across a boundary between the IC chip and the molding resin to a position overlapping with the molding resin in a plan view and is connected to the RF bump.

A seventh aspect of the present invention is the high-frequency module of the fifth aspect or the sixth aspect, wherein the rewiring connected to the RF bump passes between the GND bumps at a position overlapping with the molding resin in a plan view and is connected to the RF bump.

An eighth aspect of the present invention is the high-frequency module of any one of the fifth aspect to the seventh aspect, wherein the rewiring connected to the GND bump is disposed on both sides of the rewiring connected to the RF bump.

A ninth aspect of the present invention is the high-frequency module of any one of the first aspect to the eighth aspect, wherein the RF bump includes a first RF bump and a second RF bump which are in a relationship such that when one RF bump outputs a high-frequency signal, a high-frequency signal before being processed by the IC package is input to the other RF bump, and wherein the GND bump is disposed on the shortest line segment connecting at least the first RF bump and the inner metal pattern in a plan view.

A tenth aspect of the present invention is the high-frequency module of the first aspect to the ninth aspect, wherein the inner metal pattern includes a power supply pattern for supplying power to the IC package.

An eleventh aspect of the present invention is a phased array antenna module including: the high-frequency module of any one of the first aspect to the tenth aspect; and a phased array antenna electrically connected to the high-frequency module. Advantageous Effects of Invention

According to the present invention, it is possible to improve isolation between a bump through which a high-frequency signal passes and an inner metal pattern which overlaps with an IC package in a plan view in a small high-frequency module that handles a high-frequency signal.

### BRIEF DESCRIPTION OF DRAWINGS

[FIG. 1] A block diagram of a phased array antenna device according to an embodiment.
[FIG. 2] A main configuration diagram of the phased array antenna device according to an embodiment.
[FIG. 3] A plan view of an IC package according to an embodiment.
[FIG. 4] A cross-sectional view taken along line IV-IV shown in FIG. 3.
[FIG. 5] An enlarged view of region A shown in FIG. 3.
[FIG. 6] A schematic side view of a high-frequency module according to an embodiment.
[FIG. 7] A schematic plan view of the high-frequency module according to an embodiment.
[FIG. 8] A schematic plan view of a high-frequency module according to a first modified example.
[FIG. 9] A schematic plan view of a high-frequency module according to a second modified example.
[FIG. 10] A schematic plan view of a high-frequency module according to a third modified example.

### DESCRIPTION OF EMBODIMENTS

Hereinafter, a high-frequency module and a phased array antenna module according to an embodiment of the present invention will be described with reference to the drawings.

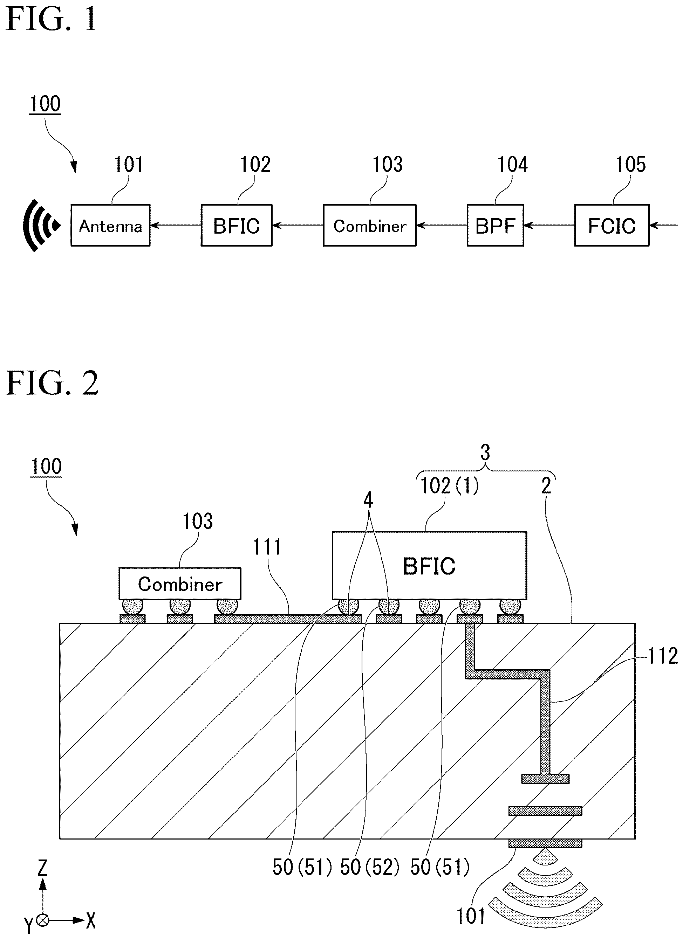

FIG. 1 is a block diagram of a phased array antenna device 100 according to an embodiment. As shown in FIG. 1, a phased array antenna device 100 includes a phased array antenna 101, a beam forming IC (BFIC) 102, an antenna combiner (combiner) 103, a band pass filter (BPF) 104, and a frequency conversion IC (FCIC) 105.

The frequency conversion IC 105 converts the frequency of the IF signal using an LO signal (to generate a high-frequency signal (RF signal)) and outputs the conversion result to the band pass filter 104. The bandpass filter 104 attenuates signals other than a predetermined frequency band, for example, attenuates an LO signal component, and outputs the high-frequency signal to the antenna combiner 103. The antenna combiner 103 distributes the high-frequency signal and outputs the high-frequency signal to each of the plurality of beam forming ICs 102.

The beam forming IC 102 applies a phase difference to the high-frequency signal and outputs the high-frequency signal to the phased array antenna 101. The phased array antenna 101 varies the beam direction according to the phase difference of the high-frequency signal. Furthermore, in FIG. 1, the flow of the high-frequency signal when transmitted is indicated by an arrow, but when the high-frequency signal is received, the signal flows in the direction opposite to that indicated by the arrow in FIG. 1.

FIG. 2 is a main configuration diagram of the phased array antenna device 100 according to an embodiment. The beam forming IC 102 is an IC package 1 (semiconductor package) and is mounted on a substrate 2 as shown in FIG. 2. The IC package 1 and the substrate 2 constitute a high-frequency module 3. Hereinafter, the beam forming IC 102 is referred to as the IC package 1, but the frequency conversion IC 105 may also be referred to as the IC package 1.

Furthermore, in the following description, an XYZ orthogonal coordinate system may be set, and the positional relationships of the various components may be described with reference to this XYZ orthogonal coordinate system. As shown in FIG. 2, the Z-axis direction is set to the thickness direction of the IC package 1 and the substrate 2 (that is, the high-frequency module 3). Hereinafter, the side of the IC package 1 with respect to the substrate 2 is referred to as the upper side or +Z side, and the side opposite to the IC package 1 with respect to the substrate 2 is referred to as the lower side or +Z side. Furthermore, the +Z side does not have to be the upper side in the direction of gravity.

As shown in FIG. 2, a plurality of pads 4 are formed on the upper surface of the substrate 2. A plurality of solder bumps 50 which are electrically connected to the plurality of pads 4 are formed on the lower surface of the IC package 1. The solder bump 50 includes an RF bump 51 through which a high-frequency signal passes and a GND bump 52 which is electrically grounded.

Further, the antenna combiner 103 is provided on the upper surface of the substrate 2. On the other hand, the phased array antenna 101 is provided on the lower surface of the substrate 2. The RF bump 51 of the IC package 1 is electrically connected to a conductor 111 extending from the antenna combiner 103. Further, the other RF bump 51 of the IC package 1 is electrically connected to a conductor 112 extending from the phased array antenna 101.

Furthermore, in the following description, the upper surface of the substrate 2 on which the IC package 1 is mounted may be referred to as the "mounting surface." Further, a module including the high-frequency module 3 and the phased array antenna 101 may be referred to as the "phased array antenna module."

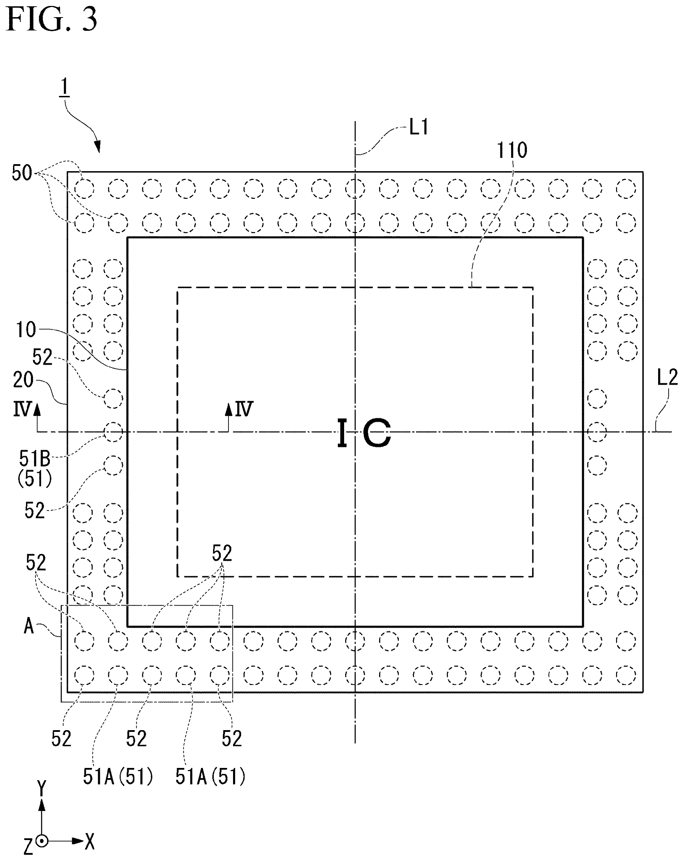

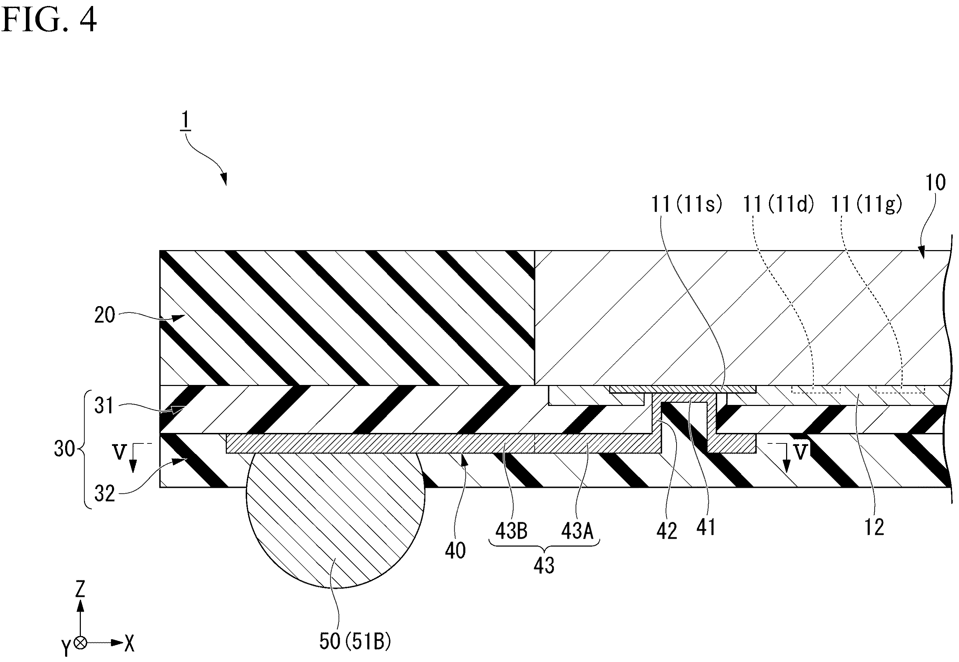

FIG. 3 is a plan view of the IC package 1 according to an embodiment. FIG. 4 is a cross-sectional view taken along line IV-IV shown in FIG. 3. Furthermore, FIG. 3 schematically shows an inner metal pattern 110 (described later) on the mounting surface formed in a portion overlapping with the IC package 1 (more specifically, an IC chip 10) in a plan view of the substrate 2.

As shown in FIGS. 3 and 4, the IC package 1 includes the IC chip 10, a molding resin 20, an insulating layer 30, a plurality of rewirings 40, and a plurality of solder bumps 50. As shown in FIG. 4, the insulating layer 30 according to this embodiment includes a first insulating layer 31 and a second insulating layer 32. The thickness of the IC package 1 excluding the solder bumps 50 is 1 mm or less (for example, about 500 µm).

Furthermore, "plan view" refers to viewing the IC package 1 from the thickness direction (Z-axis direction). That is, FIG. 3 is a plan view of the IC package 1. The "thickness direction" also refers to the direction in which the insulating layer 30 and the IC chip 10 of the IC package 1 face each other. Further, the "thickness direction" also refers to the direction in which the IC package 1 and the substrate 2 of the high-frequency module 3 face each other.

As shown in FIG. 3, the outer shape of the IC package 1 (molding resin 20) is rectangular in a plan view. Furthermore, in this specification, the term "rectangle" includes cases where the shape can be considered rectangular when manufacturing errors are removed. In the IC package 1, a first center line L1 and a second center line L2 that are orthogonal to each other in a plan view can be defined. The IC package 1 has two sides parallel to the first center line L1 and two sides parallel to the second center line L2.

Furthermore, the direction along the first center line L1 is the Y-axis direction, and the direction along the second center line L2 is the X-axis direction. The first center line L1 and the second center line L2 intersect at the center of the IC package 1 in a plan view.

The IC chip 10 includes a plurality of analog circuits (such as inductors not shown) and processes high-frequency signals. The IC chip 10 has a rectangular outer shape in a plan view. That is, the IC chip 10 has two sides parallel to the X-axis direction and two sides parallel to the Y-axis direction. In a plan view, the center of the IC chip 10 and the center of the outer shape of the IC package 1 (the outer shape of the molding resin 20) are aligned. Furthermore, in this specification, the term "alignment" also includes cases where the alignment can be considered to occur when manufacturing errors are removed.

The molding resin 20 surrounds the IC chip 10 in a plan view. As shown in FIG. 4, the IC chip 10 and the molding resin 20 are located at the same position in the thickness direction. The IC chip 10 and the molding resin 20 are in contact with each other. As a specific material for the molding resin 20, for example, epoxy can be used. Further, the molding resin 20 may contain a filler such as silica.

The IC package 1 can be manufactured by a so-called Fan Out Wafer Level Package (FOWLP) method. As a specific example, the plurality of IC chips 10 may be arranged in a lattice pattern, the molding resin 20 may be filled into the gaps between the IC chips 10, and the molding resin 20 may be cut after the rewirings 40 and the like are formed. According to this manufacturing method, the plurality of IC packages 1 can be efficiently manufactured at one time. Furthermore, as the IC package 1, a similar package having the solder bumps 50 and the molding resin 20, such as Flip Chip-Ball Grid Array (FC-BGA) method, may be used, as in the FOWLP.

As shown in FIG. 4, it is preferable that the upper surface (the end surface on the +Z side) of the IC chip 10 is not provided with the molding resin 20 or the like, and the IC chip 10 is exposed. Accordingly, the heat dissipation of the IC chip 10 can be improved. Alternatively, a structure for improving heat dissipation (a heat dissipation sheet, a heat dissipation fin, or the like) may be provided on the upper surface of the IC chip 10.

A plurality of terminals 11 are provided on the lower surface (the end surface on the -Z side) of the IC chip 10. Each terminal 11 is, for example, an aluminum pad. The plurality of terminals 11 include a high-frequency terminal 11s, a GND terminal 11g, a digital signal terminal 11d, and a power supply terminal (not shown).

The high-frequency terminal 11s is a terminal through which a high-frequency signal passes. The GND terminal 11g is electrically connected to a GND circuit (not shown) of the IC chip 10 and is a terminal at GND potential. The digital signal terminal 11d is electrically connected to a digital circuit (not shown) of the IC chip 10 and is a terminal through which a digital signal flows. The power supply terminal is a terminal for supplying driving power to each part of the IC chip 10.

The high-frequency terminal 11s is electrically connected to the solder bump 50 (RF bump 51) via the rewiring 40. Although not shown, the other terminals 11 (the GND terminal 11g, the digital signal terminal 11d, and the power supply terminal) are also electrically connected to the other solder bumps 50 via the rewirings 40.

The solder bump 50 is generally spherical. The solder bump 50 is formed on the insulating layer 30. Further, the solder bump 50 protrudes from the insulating layer 30 toward the -Z side. The material of the solder bump 50 may be SAC305, SAC405, or the like.

A passivation film 12 is provided on the lower surface of the IC chip 10. The passivation film 12 is, for example, a nitride film, an oxide film, or the like, and acts to protect the IC chip 10. However, in order to connect the terminal 11 and the rewiring 40, an opening is formed in the passivation film 12 at a portion overlapping with the terminal 11.

The first insulating layer 31 is laminated on the -Z side of the IC chip 10 and the molding resin 20. The second insulating layer 32 is laminated on the -Z side of the first insulating layer 31. That is, the insulating layer 30 is formed on the lower surfaces of the IC chip 10 and the molding resin 20. In other words, the insulating layer 30 overlaps with the IC chip 10 and the molding resin 20 in a plan view.

For example, a transparent resin (for example, polyimide or the like) can be suitably used as the material of the first insulating layer 31 and the second insulating layer 32. Furthermore, the insulating layer 30 may have a single-layer structure or a three-layer or more structure.

The rewiring 40 is formed on the insulating layer 30. The material of the rewiring 40 may be, for example, copper. The rewiring 40 has a terminal joint portion 41, a through portion 42, and an extension portion 43. The terminal joint portion 41 is joined to the terminal 11. The through portion 42 extends from the terminal joint portion 41 to the -Z side, and penetrates the first insulating layer 31 in the thickness direction.

The extension portion 43 extends in a direction orthogonal to the thickness direction (a direction along the XY plane) and is formed across the boundary between the IC chip 10 and the molding resin 20 in a plan view. Hereinafter, the portion of the extension portion 43 that overlaps with IC chip 10 in a plan view may be referred to as a fan-in portion 43A, and the portion of the extension portion 43 that overlaps with the molding resin 20 in a plan view may be referred to as a fan-out portion 43B.

In the example of FIG. 4, the solder bump 50 is joined to the fan-out portion 43B of the extension portion 43. Accordingly, for example, the RF bump 51 disposed at a position overlapping with the molding resin 20 and the high-frequency terminal 11s disposed at a position overlapping with the IC chip 10 in a plan view can be connected to each other. Furthermore, the rewiring 40 is preferably impedance matched. The shape of the rewiring 40 can be changed as appropriate. For example, the rewiring 40 connected to the solder bump 50 that overlaps with the IC chip 10 in a plan view may not have the fan-out portion 43B.

As shown in FIG. 3, the IC package 1 includes the plurality of solder bumps 50 provided at positions overlapping with the molding resin 20 in a plan view. The plurality of solder bumps 50 are arranged in line symmetry with respect to the first center line L1 and also with respect to the second center line L2 in a plan view. In this specification, the term "line symmetry" also includes cases where the structure is line symmetry when manufacturing errors are removed. Furthermore, the plurality of solder bumps 50 may not be arranged in line symmetry with respect to at least one of the first center line L1 and the second center line L2 in a plan view.

The plurality of solder bumps 50 include a first RF bump 51A and a second RF bump 51B as the RF bump 51 through which a high-frequency signal passes. The first RF bump 51A and the second RF bump 51B have a relationship such that when one RF bump 51 outputs a high-frequency signal, the high-frequency signal before being processed by the IC package 1 is input to the other RF bump 51.

The first RF bump 51A is the RF bump 51 which outputs a high-frequency signal when transmitting a high-frequency signal or to which a high-frequency signal is input when receiving a high-frequency signal. The first RF bump 51A is electrically connected to the above-described phased array antenna 101 (see FIG. 2). The phased array antenna 101 includes a plurality of antenna elements (for example, 4×4 antenna elements) arranged in an array. The first RF bump 51A is provided at a plurality of positions corresponding to the plurality of antenna elements. The plurality of first RF bumps 51A are provided alternately with the GND bumps 52 along two sides of the outermost edge of the IC package 1 (the outermost edge of the molding resin 20) that extend parallel to the X-axis direction.

The second RF bump 51B is the RF bump 51 which outputs a high-frequency signal when receiving a high-frequency signal or to which a high-frequency signal is input when transmitting a high-frequency signal. The second RF bump 51B is electrically connected to the above-described antenna combiner 103 (see FIG. 2). The second RF bump 51B is disposed on the second center line L2 of the IC package 1. The second RF bump 51B is disposed on the side of the IC chip 10 inside the outermost edge of the IC package 1. Furthermore, the second RF bump 51B may be disposed on the outermost edge side of the IC package 1.

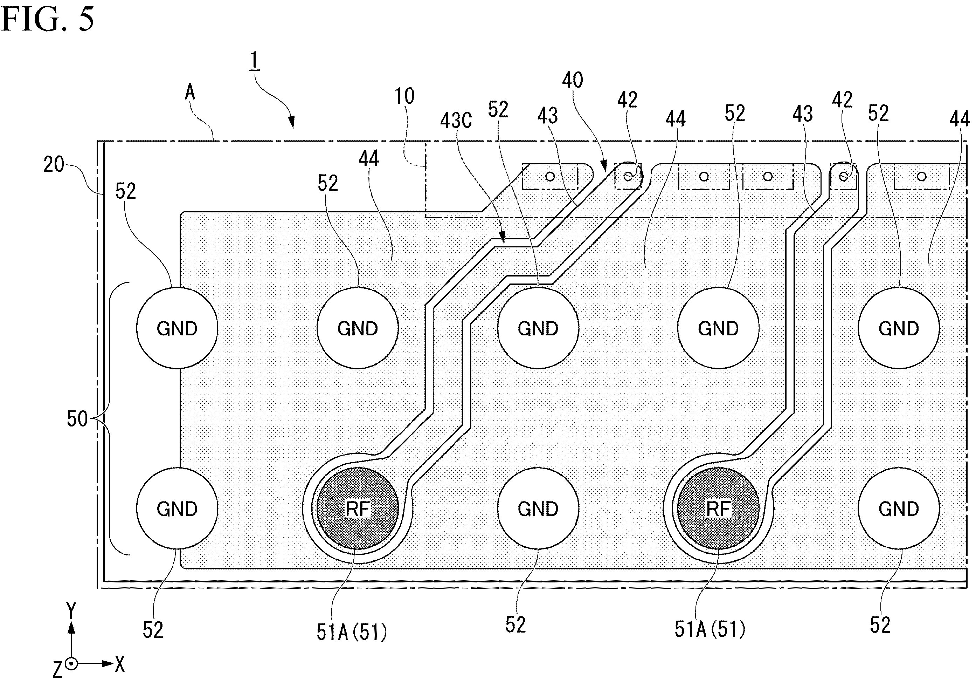

FIG. 5 is an enlarged view of region A shown in FIG. 3. FIG. 5 is a view corresponding to the cross-section V-V of FIG. 4 in the region A of FIG. 3. Furthermore, in the cross-section V-V, the solder bumps 50 (the RF bump 51 and the GND bump 52) are arranged on the -Z side of the rewiring 40. In FIG. 5, in order to improve the visibility, the solder bumps 50 (the RF bump 51 and the GND bump 52) arranged on the -Z side of the rewiring 40 are shown in a see-through manner.

As shown in FIG. 5, the plurality of first RF bumps 51A are provided around the IC chip 10 in a plan view. Further, the first RF bump 51A is disposed on the outermost edge of the molding resin 20 in a plan view. That is, the GND bump 52 is not disposed on the outside of the first RF bump 51A. The GND bumps 52 are arranged to surround one first RF bump 51A in a plan view.

The rewiring 40 (extension portion 43) connected to the first RF bump 51A passes between the adjacent GND bumps 52 at a position overlapping with the molding resin 20 in a plan view, and is connected to the first RF bump 51A. Specifically, in FIG. 5, the rewiring 40 (extension portion 43) connected to the first RF bump 51A disposed on the +X side extends from the through portion 42 in a diagonal direction of 45° and then passes between the GND bumps 52 adjacent to each other in the X-axis direction.

Further, in FIG. 5, the rewiring 40 (extension portion 43) connected to the first RF bump 51A disposed on the -X side extends from the through portion 42 in a diagonal direction of 45°, then bypasses the GND bump 52 located on the extension line, and passes between the GND bumps 52 adjacent to each other in the X-axis direction. That is, the rewiring 40 (extension portion 43) connected to the first RF bump 51A disposed on the -X side has a bypass portion 43C that bypasses the GND bump 52 in a substantially C-shape. That is, in FIG. 5, the bypass portion 43C is formed in a substantially C-shape. Furthermore, the distance between the GND bumps 52 adjacent to each other in the X-axis direction is preferably about 300 µm to 500 µm.

The GND bump 52 is further disposed between the first RF bumps 51A adjacent to each other in the X-axis direction. Accordingly, the isolation between the first RF bumps 51A adjacent to each other can be improved. Further, solid patterns 44 of the rewiring 40 connected to the GND bump 52 are arranged on both sides of the rewiring 40 connected to the first RF bump 51A. Accordingly, the isolation between the adjacent first RF bumps 51A can be further improved.

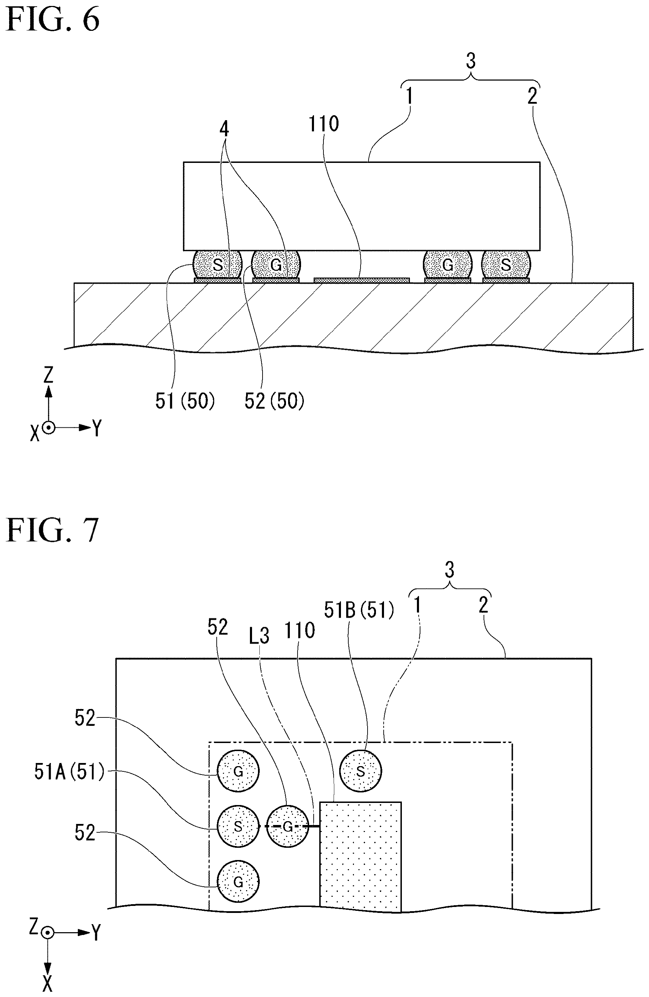

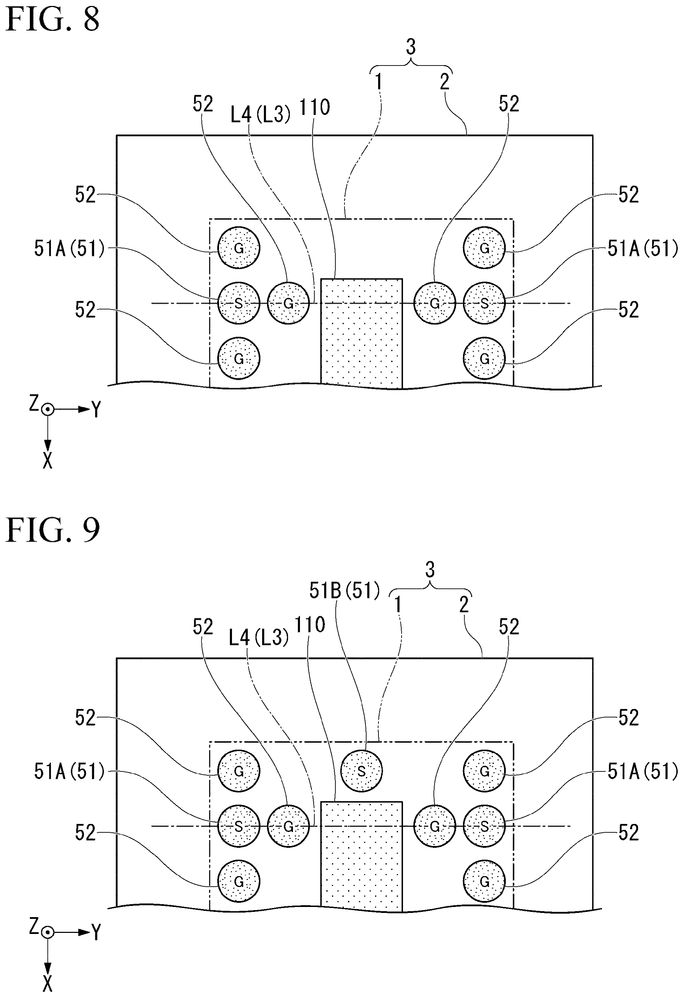

FIG. 6 is a schematic side view of the high-frequency module 3 according to an embodiment. FIG. 7 is a schematic plan view of the high-frequency module 3 according to an embodiment. Furthermore, in FIG. 7, the outer shape of the IC package 1 is shown by a two-dot chain line in order to improve the visibility of the inner metal pattern 110 on the mounting surface formed in the portion of the substrate 2 that overlaps with the IC package 1 in a plan view. This is the same as in FIG. 6 in FIGS. 8 to 11 described later.

As shown in FIGS. 6 and 7, the inner metal pattern 110 which is not electrically grounded is formed on the mounting surface of the substrate 2 in a portion that overlaps with the IC package 1 in a plan view. Furthermore, the inner metal pattern 110 may be the uppermost layer of the metal pattern on the substrate 2. That is, the inner metal pattern 110 does not necessarily have to be formed on the surface of the substrate 2, but may be formed, for example, in an inner layer of the substrate 2. The inner metal pattern 110 of this embodiment includes a power supply pattern that supplies power to the IC package 1. The power supply pattern is connected to a power supply terminal (not shown) of the above-described IC chip 10. Furthermore, the inner metal pattern 110 may include a signal pattern for transmitting a signal (for example, a digital signal or a high-frequency signal) to the IC package 1. In other words, the inner metal pattern 110 is any one of a high-frequency signal pattern, a digital signal pattern, and a power supply pattern that is located inside the IC package 1 in a plan view. The plurality of RF bumps 51 are provided around the inner metal pattern 110.

As shown in FIG. 7, the GND bump 52 is disposed on the shortest line segment L3 that connects the first RF bump 51A and the inner metal pattern 110 in a plan view. The center of the GND bump 52 disposed on the shortest line segment L3 is located on the shortest line segment L3. Furthermore, the GND bump 52 disposed on the shortest line segment L3 may be formed so that at least a part thereof is located on the shortest line segment L3. Furthermore, in this embodiment, the "line segment" is a line that has finite ends, and is distinguished from a "straight line" that has no ends and continues forever.

In a plan view of the mounting surface of the substrate 2, the GND bump 52 disposed on the shortest line segment L3 connecting the first RF bump 51A and the inner metal pattern 110 acts as a wall that suppresses leakage of a high-frequency signal that occurs when a high-frequency signal is transmitted from the first RF bump 51A to the inner metal pattern 110. Therefore, it is possible to improve the isolation between the inner metal pattern 110 and the first RF bump 51A through which a high-frequency signal passes.

Furthermore, although it is possible to check the isolation between the rewiring 40, the RF bump 51, and the inner metal pattern 110 in the high-frequency module 3 in advance by simulation or the like, this requires a lot of man-hours. Therefore, simulation becomes unnecessary, and unnecessary man-hours can be reduced by appropriately arranging the GND bumps 52 and taking measures against leakage of high-frequency signals as in this embodiment.

In this way, the high-frequency module 3 according to this embodiment includes the IC package 1 in which the plurality of solder bumps 50 are arranged on a plane and the substrate 2 which has a mounting surface for mounting the IC package 1, wherein the inner metal pattern 110 which is not electrically grounded is formed on the mounting surface at a portion overlapping with the IC package 1 in a plan view, the plurality of solder bumps 50 include the RF bump 51 through which a high-frequency signal passes and the GND bump 52 which is electrically grounded, and the GND bump 52 is disposed on the shortest line segment L3 connecting the RF bump 51 and the inner metal pattern 110 in a plan view. According to this configuration, it is possible to improve the isolation between the RF bump 51 through which a high-frequency signal passes and the inner metal pattern 110 which overlaps with the IC package 1 in a plan view in the small high-frequency module 3 that handles a high-frequency signal.

Further, in this embodiment, the RF bump 51 includes the first RF bump 51A and the second RF bump 51B, which are in a relationship such that when one RF bump 51 outputs a high-frequency signal, a high-frequency signal before being processed by the IC package 1 is input to the other RF bump 51. The GND bump 52 is disposed on the shortest line segment L3 connecting at least the first RF bump 51A and the inner metal pattern 110 in a plan view. According to this configuration, it is possible to suppress a high-frequency signal from leaking from the first RF bump 51A through which a high-frequency signal passes to other contacts (the second RF bump 51B) via the inner metal pattern 110.

Furthermore, in this embodiment, the GND bump 52 is not disposed on the shortest line segment connecting the second RF bump 51B and the inner metal pattern 110, but the GND bump 52 may be disposed as in the first RF bump 51A. Furthermore, the IC package 1 can be made smaller by not disposing the GND bump 52.

Further, in this embodiment, the plurality of first RF bumps 51A are provided around the inner metal pattern 110 in a plan view, and the GND bump 52 is further disposed between the first RF bumps 51A adjacent to each other (see FIG. 5). According to this configuration, the isolation between the first RF bumps 51A adjacent to each other can be improved.

Further, in this embodiment, the first RF bump 51A is disposed on the outermost edge of the IC package 1 in a plan view. According to this configuration, since the GND bump 52 is not disposed on the outside of the first RF bump 51A, the IC package 1 can be made smaller.

Further, in this embodiment, the IC package 1 includes the IC chip 10, the molding resin 20 which surrounds the IC chip 10 in a plan view, the insulating layer 30 which is formed on one surface of the IC chip 10 and the molding resin 20, the plurality of solder bumps 50 which are formed on the insulating layer 30, and the rewiring 40 which is formed on the insulating layer 30 and connects the IC chip 10 to the plurality of solder bumps 50. According to this configuration, it is possible to form the inner metal pattern 110 which is not electrically grounded by using a portion of the substrate 2 overlapping with the IC package 1 in a plan view in the FOWLP type IC package 1. Further, since it is possible to suppress leakage of the high-frequency signal via the inner metal pattern 110 by disposing the GND bump 52 as appropriate, a small-sized and high-performance high-frequency module 3 is obtained.

Further, in this embodiment, the rewiring 40 connected to the RF bump 51 extends across the boundary between the IC chip 10 and the molding resin 20 to a position overlapping with the molding resin 20 in a plan view, and is connected to the RF bump 51. According to this configuration, the rewiring 40 connected to the RF bump 51 extends in a direction moving away from the inner metal pattern 110. Therefore, the isolation between the rewiring 40 and the inner metal pattern 110 can be improved.

Further, in this embodiment, the rewiring 40 connected to the first RF bump 51A passes between the GND bumps 52 adjacent to each other at a position overlapping with the molding resin 20 in a plan view, and is connected to the RF bump 51. According to this configuration, the GND bump 52 is disposed on both sides of the rewiring 40 while the rewiring 40 connected to the first RF bump 51A extends in a direction moving away from the inner metal pattern 110. Therefore, the isolation between the rewiring 40 and the inner metal pattern 110 can be further improved.

Further, in this embodiment, the rewiring 40 (the solid pattern 44) connected to the GND bump 52 is disposed on both sides of the rewiring 40 connected to the RF bump 51 (see FIG. 5). According to this configuration, the solid pattern 44 to which the GND bumps 52 are connected is disposed on both sides of the rewiring 40. Therefore, the isolation between the rewiring 40 and the inner metal pattern 110 can be further improved.

Further, in this embodiment, the inner metal pattern 110 includes a power supply pattern that supplies power to the IC package 1. According to this configuration, it is possible to suppress a high-frequency signal from leaking from the RF bump 51 through which a high-frequency signal passes to other contacts via the power supply pattern.

The phased array antenna module according to this embodiment includes the high-frequency module 3 and the phased array antenna 101 electrically connected to the high-frequency module 3. According to this configuration, a small-sized and high-performance phased array antenna module is obtained.

Furthermore, in this embodiment, the configurations shown in the following FIGS. 8 to 11 can be adopted.

In the high-frequency module 3 shown in FIG. 8, the first RF bump 51A, the GND bump 52, the inner metal pattern 110, another GND bump 52, and another first RF bump 51A are arranged in this order on the straight line L4 including the shortest line segment L3 which is an extension of both ends of the shortest line segment L3 connecting the first RF bump 51A and the inner metal pattern 110. According to this configuration, it is possible to improve the isolation between the first RF bump 51A and the inner metal pattern 110 on both sides of the inner metal pattern 110.

Further, the second RF bump 51B may be disposed as shown in FIG. 9. In this case, it is possible to suppress a high-frequency signal from leaking from the first RF bump 51A disposed on both sides of the inner metal pattern 110 to the second RF bump 51B.

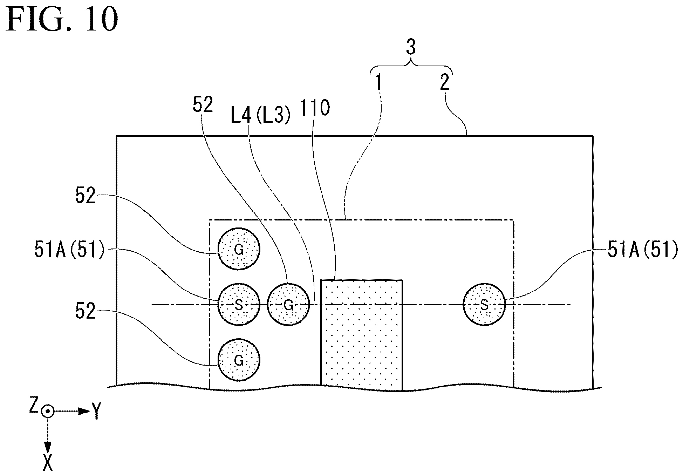

Further, as shown in FIG. 10, the first RF bump 51A may not be surrounded by the GND bump 52 on one of the two sides of the inner metal pattern 110.

Further, as shown in FIGS. 7 and 10, the GND bump 52 may be disposed on the shortest line segment L3 connecting at least one first RF bump 51A and the inner metal pattern 110.

While preferred embodiments of the present invention have been described and illustrated, it should be understood that they are illustrative of the present invention and are not to be considered as limiting. Additions, omissions, substitutions, and other modifications may be made without departing from the scope of the present invention. Therefore, the present invention should not be regarded as limiting by the foregoing description, but is limited only by the scope of the claims.

For example, the outer shape of the molding resin 20 may be square in a plan view. Similarly, the outer shape of the IC chip 10 may be square in a plan view. That is, the outer shape of each of the IC chip 10 and the molding resin 20 may be rectangular. Furthermore, in this specification, the term "square" also includes cases where the shape can be regarded as square when manufacturing errors are removed.

Further, for example, the center of the molding resin 20 and the center of the IC chip 10 may not be aligned in a plan view.

Further, for example, an underfill may be applied between the IC package 1 and the substrate 2. The underfill may contain fillers such as epoxy and silica. In this case, the mechanical connection strength between the IC package 1 and the substrate 2 can be increased.

In addition, the components in the above-described embodiments can be replaced with well-known components as appropriate within the scope of the spirit of the present invention, and the above-described embodiments and modified examples may be combined as appropriate.

### REFERENCE SIGNS LIST

1 IC package
2 Substrate
3 High-frequency module
4 Pad
10 IC chip
11 Terminal
11d Digital signal terminal
11g GND terminal
11s High-frequency terminal
12 Passivation film
20 Molding resin
30 Insulating layer
31 First insulating layer
32 Second insulating layer
40 Rewiring
41 Terminal joint portion
42 Through portion
43 Extension portion
43A Fan-in portion
43B Fan-out portion
43C Bypass portion
44 Solid pattern
50 Bump
51 RF bump
51A First RF bump
51B Second RF bump
52 GND bump
100 Phased array antenna device
101 Phased array antenna
103 Antenna combiner
104 Band pass filter
110 Inner metal pattern
111 Conductor
112 Conductor
102 Beam forming IC
105 Frequency conversion IC
L1 First center line
L2 Second center line
L3 Shortest line segment
L4 Straight line

## Claims

1. A high-frequency module comprising:
an IC package in which a plurality of solder bumps are arranged on a plane; and
a substrate which has a mounting surface for mounting the IC package,
wherein an inner metal pattern is formed on the substrate to be disposed at a portion overlapping with the IC package in a plan view,
wherein the plurality of solder bumps include
an RF bump through which a high-frequency signal passes, and
a GND bump which is electrically grounded, and
wherein the GND bump is disposed on a shortest line segment connecting the RF bump and the inner metal pattern in a plan view.

2. The high-frequency module according to claim 1,
wherein the RF bump is provided at a plurality of positions around the inner metal pattern in a plan view, and
wherein the GND bump is further disposed between the RF bumps adjacent to each other.

3. The high-frequency module according to claim 1 or 2,
wherein the RF bump is disposed on an outermost edge of the IC package in a plan view.

4. The high-frequency module according to any one of claims 1 to 3,
wherein the RF bump, the GND bump, the inner metal pattern, another GND bump, and another RF bump are arranged in this order on a straight line including the shortest line segment which is an extension of both ends of the shortest line segment connecting the RF bump and the inner metal pattern.

5. The high-frequency module according to any one of claims 1 to 4,
wherein the IC package includes
an IC chip,
a molding resin which surrounds the IC chip in a plan view,
an insulating layer which is formed on one surface of the IC chip and the molding resin,
the plurality of solder bumps which are formed on the insulating layer, and
a rewiring which is formed on the insulating layer and connects the IC chip to the plurality of solder bumps.

6. The high-frequency module according to claim 5,
wherein the rewiring connected to the RF bump extends across a boundary between the IC chip and the molding resin to a position overlapping with the molding resin in a plan view, and is connected to the RF bump.

7. The high-frequency module according to claim 5 or 6,
wherein the rewiring connected to the RF bump passes between the GND bumps at a position overlapping with the molding resin in a plan view, and is connected to the RF bump.

8. The high-frequency module according to any one of claims 5 to 7,
wherein the rewiring connected to the GND bump is disposed on both sides of the rewiring connected to the RF bump.

9. The high-frequency module according to any one of claims 1 to 8,
wherein the RF bump includes a first RF bump and a second RF bump, which are in a relationship such that when one RF bump outputs a high-frequency signal, a high-frequency signal before being processed by the IC package is input to the other RF bump, and
wherein the GND bump is disposed on the shortest line segment connecting at least the first RF bump and the inner metal pattern in a plan view.

10. The high-frequency module according to any one of claims 1 to 9,
wherein the inner metal pattern includes a power supply pattern for supplying power to the IC package.

11. A phased array antenna module comprising:
the high-frequency module according to any one of claims 1 to 10; and
a phased array antenna electrically connected to the high-frequency module.
